# EUROPEAN PATENT APPLICATION

(11) **EP 1 724 366 A2**
(43) Date of publication of application: **22.11.2006**
(21) Application number: 06015557.9
(22) Date of filing: 11.05.2005
(51) Int. Cl.: C22C 5/04, C23C 14/34

(54) **Low oxygen content alloy compositions**

(30) Priority: 12.10.2004 US 961215
(62) Divisional of application: 05252881.7
(71) Applicant: Heraeus, Inc., Chandler, AZ 85226 (US)
(72) Inventor: Ziani, Abdelouahab, Chandler AZ 85226 (US); Apprill, Jon, Tempe AZ 85282 (US); Furgason, David, Gilbert AZ 85226 (US)
(74) Representative: Hill, Justin John

(57) **Abstract**

Alloy compositions include Mn alloys that combine Mn with one element selected from Ga, In, Ni and Zn. Also included are Fe alloys and Co alloys in which Fe or Co are combined with either Pt or Pd. The alloy compositions form ordered compounds having L1₀ or L1₂ type crystalline structures within specified compositional ranges. In addition, the alloy compositions have low levels of impurities, such as oxygen and sulfur, which provide better performance in magnetic memory applications. The alloy compositions preferably are formed into sputtering targets used for thin film applications.

## Description

### Field of the Invention

The invention concerns low oxygen content alloy compositions, and more particularly concerns low oxygen content alloy compositions having magnetic properties useful in magnetic memory applications.

### Background of the Invention

Magnetoresistive (MR) heads and Magnetic Random Access Memory (MRAM) are expected to be key technologies for future generations of vertical magnetic recording and cell phone memory applications. New materials are being studied in order to improve designs that will increase memory area density and reduce the size of memory chips. Not only must these new materials possess particular magnetic properties for use in these technologies, they must also have high purity levels.

Material purity plays a significant role in the performance of thin film materials used in magnetic data storage and MRAM applications. For example, the presence of impurities such as oxygen, nitrogen, sulfur and alkalides alters the lattice structure of a thin film material and thereby displaces atoms in the lattice. This effect on the structural order of the material degrades the material's magnetic properties and therefore its performance in magnetic memory applications. In addition, the presence of impurities such as oxygen can produce short diffusion paths through the thin film material into the magnetic layers. Accordingly, there is a need to identify and develop thin film materials having particular magnetic properties as well as high levels of purity.

### Summary of the Invention

The present invention comprises a series of alloy compositions having preferred magnetic properties for use in magnetic memory applications. The alloy compositions form ordered compounds having L1₀ or L1₂ type crystalline structures within the claimed compositional ranges. In addition, the alloy compositions of the invention have low levels of impurities, such as oxygen and sulfur, which provide better performance in magnetic memory applications. The alloy compositions preferably are formed into sputtering targets used for thin film applications.

The alloy compositions of the invention include Mn alloys that combine Mn with one element selected from Ga, In, Ni and Zn. Also included in the alloy compositions are Fe alloys and Co alloys, in which Fe or Co are combined with either Pt or Pd.

The oxygen content of the alloy compositions of the invention is 500 ppm or less and preferably 100 ppm or less. Additionally, the sulfur content of the alloy compositions is 100 ppm or less and preferably 50 ppm or less.

The foregoing summary of the invention has been provided so that the nature of the invention may be understood quickly. A more complete understanding of the invention can be obtained by reference to the following detailed description of the invention.
According to a first aspect of the present invention there is provided an alloy composition comprising 60-24 at. % Co and 40-76 at. % Pt, wherein the alloy composition contains 500 ppm or less O and 100 ppm or less S.
According to another aspect of the present invention there is provided an alloy composition comprising 25-10 at. % Co and 75-90 at. % Pt, wherein the alloy composition contains 500 ppm or less O and 100 ppm or less S.

### Brief Description of the Drawings

Figure 1 is an optical micrograph of an as-cast Ni40Mn at. % alloy.

Figure 2 is an optical micrograph of an as-cast Ni30Mn at. % alloy.

Figure 3 is an SEM micrograph of an as-cast In50Mn at. % alloy.

Figure 4 is an optical micrograph of an as-cast Fe45Pt at. % ordered alloy.

### Detailed Description of the Invention

The inventors identified and developed a series of alloy compositions that exhibited preferred magnetic characteristics and had low impurity levels. The alloy compositions of the invention form ordered compounds having L1₀ or L1₂ type crystalline structures. In addition, the oxygen and sulfur content of the alloy compositions was significantly reduced.

Table 1 summarizes the relevant compositional and structural data for the alloy compositions of the present invention. Specifically, Table 1 identifies the ordered phase symbol, the structure designation, the composition range in which the phase of interest exists, and the compositional range in which the phase of interest could coexist with other phase types. The phase symbols used in Table 1 were obtained from phase diagrams found in Binary Phase Diagrams, 2nd Edition (Thaddeus B. Massalski, ed.).

**TABLE 1**

| Alloy System X-Y | Ordered Phase Symbol | Structure Designation | Composition at.% Y | Compositional Range at.%Y |
|---|---|---|---|---|
| Mn-Ga | γ₃ | L1₀ | 55-63 | 50-70 |
| Mn-In | InMn₃ | L1₀ or L1₂ | 75 | 50-85 |
| Mn-Ni | η' | L1₀ | 47-55.5 | 44-60 |
| Ni-Mn | γ' | L1₂ | 15-29 | 10-30 |
| Zn-Mn | α' | L1₂ | 25-31 | 20-40 |
| Zn-Mn | α₁' | L1₀ | 25-30 | 20-40 |
| Fe-Pt | Fe₃Pt | L1₂ | 16-33 | 16-35 |
| Fe-Pt | FePt | L1₀ | 35-55 | 35-59 |
| Fe-Pt | FePt₃ | L1₂ | 57-79 | 57-83 |
| Fe-Pd | FePd(a) | L1₀ | 48.5-60 | 30-63 |
| Fe-Pd | FePd₃(b) | L1₂ | 63-86 | 60-88 |
| Co-Pt | CoPt(a) | L1₀ | 42-74 | 40-76 |
| Co-Pt | CoPt₃(b) | L1₂ | 75-88 | 75-90 |
| Co-Pd | α" | L1₀ | 48-52 | 30-58 |
| Co-Pd | α' | L1₂ | 60-90 | 58-94 |

The first group of alloys listed in Table 1 comprises Mn alloys which exhibit L1₀ or L1₂ crystalline structures. These Mn alloys possess antiferromagnetic properties desirable for thin film materials used in magnetic data storage and MRAM applications. Specifically, these Mn alloys are of interest for use in anisotropic magnetoresistive (AMR) and giant magnetoresistive (GMR) spin-valve sensors used in high-density recording. These Mn alloys are also of interest since the alloy constituents used with Mn are lower cost materials than those typically used, such as Pt, Pd, Ir or Rh. Examples 1 and 2 below describe Mn-Ni alloys and an Mn-In alloy, respectively, according to embodiments of the present invention.

Example 1: A series of three Ni-Mn melt tests were conducted. The melt charge compositions for each of the tests are shown below in Table 2. The melt charge compositions were made using 99.95% pure Ni shots and 99.9% pure Mn flakes.

**TABLE 2**

| Melt Charge Constitution | First Ni-Mn Melt Test | Second Ni-Mn Melt Test | Third Ni-Mn Melt Test |
|---|---|---|---|
| Ni Input (g) | 630.0 | 6477.5 | 4886.0 |
| Mn Input (g) | 870.0 | 3583.1 | 2094.0 |
| CaSi₂ Input (g) | 13.1 | 60.0 | 20.0 |
| Ce Input (g) | 7.9 | 77.4 | None |

In the first melt test, an alloy ingot was directly solidified in an MgO crucible. In the second and third melt tests, the alloys were melted and cast into graphite molds. The graphite molds were BN sprayed and pre-heated to 500 F in a separate furnace prior to being installed in a VIM unit chamber. For all three melt tests, the VIM unit chamber was evacuated to about 0.05 mbar in preparation for the melting operation.

The melting operation for all three tests was performed by powering the VIM unit to 5kW for 20 minutes and increasing the power by 5kW every 5 minutes for an additional 20 minutes. Once the Mn flakes began melting, the VIM unit chamber was back filled with argon to a pressure of about 40 mbar for the first test. For the second and third tests, the VIM unit chamber was subsequently back filled with argon to 500 mbar at 25 minutes and then to 700 mbar at 37 minutes.

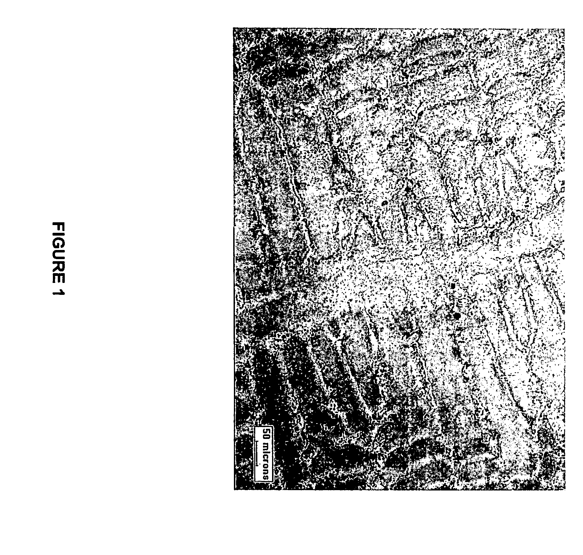

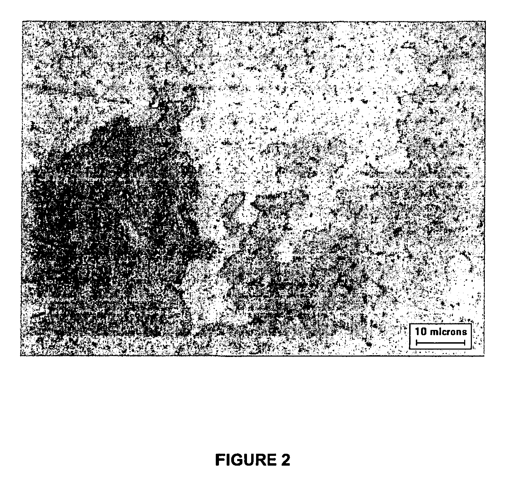

Samples of the alloys were prepared from the bulk of the ingots for analyzing chemical composition. Inspection of the MgO crucible and the graphite molds after the ingots were turned out revealed no noticeable signs of erosion. Figures 1 and 2 are optical micrographs depicting the microstructures of the as-cast Ni40Mn at. % alloy and the as-cast Ni30Mn at. % alloy, respectively. The results of the chemical analysis of the alloy samples from the three melt tests are shown below in Table 3.

**TABLE 3**

| | Si ppm | Ca ppm | Ce ppm | Mg ppm | Na ppm | K ppm | O ppm | C ppm | N ppm | S ppm | Mn wt.% |
|---|---|---|---|---|---|---|---|---|---|---|---|
| First Melt Test | 4979 | 166 | 52 | 35 | / | / | 10 | 170 | 37 | 36 | 57.94 |
| Second Melt Test | 655 | 3 | 49 | 78 | 18 | 0 | 20 | 139 | 28 | 10 | 32.28 |
| Third Melt Test | 240 | / | 43 | 0 | / | 1 | 64 | 98 | 62 | 15 | 28.61 |

As shown in Table 3, each of the three melted alloys were sufficiently deoxidized, with none of the oxygen levels exceeding 100 ppm. Comparing the oxygen levels of the first and second melt tests with that of the third melt tests reveals that Ce also contributes to the deoxidization of the alloy compositions. Furthermore, with a measured sulfur content of the Mn flakes being around 300 ppm, the data shown in Table 3 indicate that CaSi₂ also plays a role in the desulfurization of the alloy melts. In table 3, "/" indicates that no measurement was taken for the particular element and "0" indicates that the particular element was not detected.

Example 2: A melt test was conducted using 2427 grams of 99.9% pure Mn flakes and 5073 grams of 99.9% pure In rods. In addition to the Mn and In constituents, 25 grams of CaSi₂ and 10 grams of Ce were added as deoxidizers. The melt charge was preheated to 500 F under a 0.07 mbar partial vacuum in an MgO crucible within a VIM unit chamber. The VIM unit chamber was then back filled with argon to 500 mbar and the melt charge melted by applying 5kW to the VIM unit for 20 minutes and increasing the power by 5kW every 5 minutes for an additional 20 minutes. The melt charge was then cast into a graphite mold.

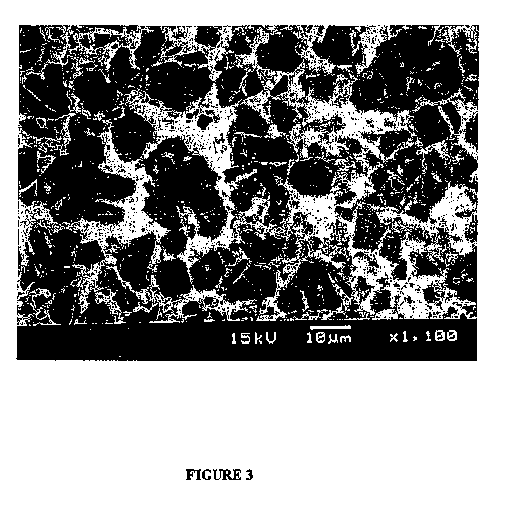

Figure 3 is an SEM micrograph depicting the microstructure of the as-cast In50Mn at. % alloy. The microstructure depicted in this micrograph consists of three phases: a light Indium matrix, an (In,Mn) solid solution shown as a light gray phase, and an InMn₃ compound shown as dark gray grains. The black spots in the micrograph are pores. The chemical composition of the as-cast material was analyzed, the results of which are shown below in Table 4.

**TABLE 4**

| Si Ppm | Cu ppm | Al ppm | Ni ppm | Fe ppm | O ppm | C Ppm | N ppm | S Ppm | Mn at.% |
|---|---|---|---|---|---|---|---|---|---|
| 15 | 2 | 10 | 6 | 23 | 40 | 62 | 19 | 33 | 50.7 |

Also included in the alloys described in Table 1 are Fe and Co alloys. In these alloys, Fe or Co is combined with either Pt or Pd to form the alloy composition. These alloy compositions are of interest for future generations of recording media using vertical recording technology, which are expected to reach a capacity of 200 GB or more. These alloy compositions are of particular interest for forming magnetic hard layers for which a high anisotropic constant (K_{µ} > 10⁷ J.m⁻¹) can be achieved. Example 3 below describes one example of an Fe-Pt alloy composition.

Example 3: A melt test was conducted using 13.500 kg of 99.9% pure Pt shots and 4.724 kg of 99.97% pure electrolytic Fe flake. 91 g (~0.50 wt.%) of CaSi₂ was added to the melt charge for deoxidation. The charge was arranged in a magnesia crucible with alternate layers of Pt and Fe with the CaSi₂ equally distributed between the layers. The VIM unit chamber was sealed and a vacuum drawn to an initial level of 0.07 mbar. The chamber was then back filled with argon and maintained at 500 mbar pressure during melting and casting. The melt was performed by powering the VIM unit to 5kW for 20 minutes and then increasing the power by 5kW every 5 minutes for an additional 20 minutes. The mold system was a graphite shell 8.00" wide, 15.00" long and 0.60" thick.

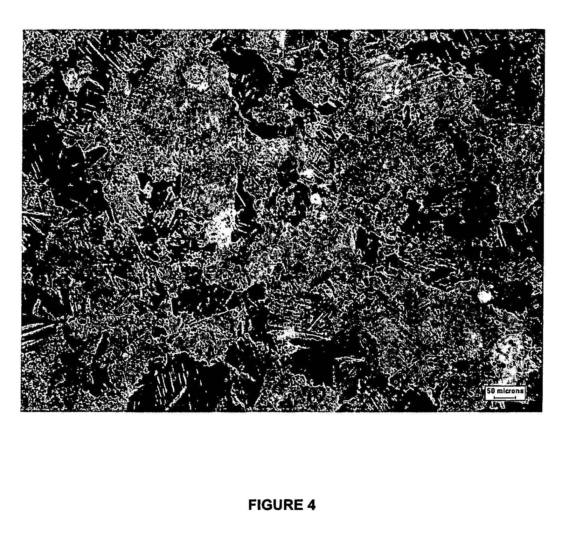

Figure 4 is an optical micrograph depicting the microstructure of the as-cast Fe45Pt at. % alloy. The microstructure consists of heavily twinned grains of the single-phase FePt described in Table 1 above. The twinned grains attribute to lattice distortion during the transformation of (γFe,Pt) fcc solid solution into tetragonal FePt at 1300 C. The chemical composition of the as-cast material was analyzed, the results of which are shown below in Table 5.

**TABLE 5**

| Al ppm | Cu ppm | Ni ppm | Si ppm | Ta ppm | Au ppm | Re ppm | O ppm | C ppm | N ppm | S ppm | Fe wt.% |
|---|---|---|---|---|---|---|---|---|---|---|---|
| <5 | <5 | <5 | 90 | 23 | 200 | 515 | 34 | 27 | 4 | 10 | 25.77 |

The foregoing examples are intended to illustrate examples of alloy compositions according to the present invention. These examples are not intended to limit the scope and the invention, which should be interpreted from the claims set forth below.

While the foregoing has described what are considered to be the best mode and/or other examples, it is understood that various modifications may be made therein and that the subject matter disclosed herein may be implemented in various forms and examples, and that they may be applied in numerous applications, only some of which have been described herein.

## Claims

1. An alloy composition comprising 60-24 at. % Co and 40-76 at. % Pt, wherein the alloy composition contains 500 ppm or less O and 100 ppm or less S.

2. The alloy composition according to Claim 1, wherein the alloy composition comprises 58-26 at. % Co and 42-74 at. % Pt.

3. The alloy composition according to Claim 1, wherein the alloy composition contains 100 ppm or less O and 50 ppm or less S.

4. An alloy composition comprising 25-10 at. % Co and 75-90 at. % Pt, wherein the alloy composition contains 500 ppm or less O and 100 ppm or less S.

5. The alloy composition according to Claim 4, wherein the alloy composition comprises 25-12 at. % Co and 75-88 at. % Pt.

6. The alloy composition according to Claim 4, wherein the alloy composition contains 100 ppm or less O and 50 ppm or less S.

7. A sputtering target comprising an alloy composition according to any one of Claims 1 to 6.
